(19) Europäisches Patentamt
European Patent Office
Office européen des brevets

(11) EP 3 041 224 A1

(12) EUROPEAN PATENT APPLICATION
published in accordance with Art. 153(4) EPC

(43) Date of publication:
06.07.2016 Bulletin 2016/27

(51) Int Cl.:
*H04N 5/374* (2011.01)    *H01L 27/146* (2006.01)
*H03K 17/687* (2006.01)

(21) Application number: 14838936.4

(22) Date of filing: 07.08.2014

(86) International application number:
PCT/JP2014/070870

(87) International publication number:
WO 2015/029740 (05.03.2015 Gazette 2015/09)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 29.08.2013 JP 2013178198

(71) Applicant: Olympus Corporation
Shibuya-ku
Tokyo 151-0072 (JP)

(72) Inventors:
• YAMAZAKI Susumu
Tokyo 151-0072 (JP)
• HAGIHARA Yoshio
Tokyo 151-0072 (JP)

(74) Representative: Gunzelmann, Rainer
Wuesthoff & Wuesthoff
Patentanwälte PartG mbB
Schweigerstraße 2
81541 München (DE)

(54) **SWITCHING CIRCUIT, SAMPLE AND HOLD CIRCUIT, AND SOLID-STATE IMAGING DEVICE**

(57)     A switching circuit includes a semiconductor layer including a source region, a drain region, and a channel region disposed between the source region and the drain region, a gate electrode disposed to be opposite to the channel region, a source wiring formed of a first material having higher conductivity than the semiconductor layer and connected to the source region, a drain wiring formed of a second material having higher conductivity than the semiconductor layer and connected to the drain region, and a decoupling wiring formed of a third material having higher conductivity than the semiconductor layer and disposed between the source wiring and the drain wiring. The source region and the drain region are in a conductive state in a first period according to a voltage of the gate electrode and the source region and the drain region are in a non-conductive state in a second period different from the first period. The voltage of the source wiring or the drain wiring changes in the second period. The voltage of the decoupling wiring is constant in the second period.

FIG. 1

**Description**

[Technical Field]

The present invention relates to a switching circuit for use in an analog circuit, a sample and hold circuit having the switching circuit, and a solid-state imaging device.

Priority is claimed on Japanese Patent Application No. 2013-178198, filed August 29, 2013, the content of which is incorporated herein by reference.

[Background Art]

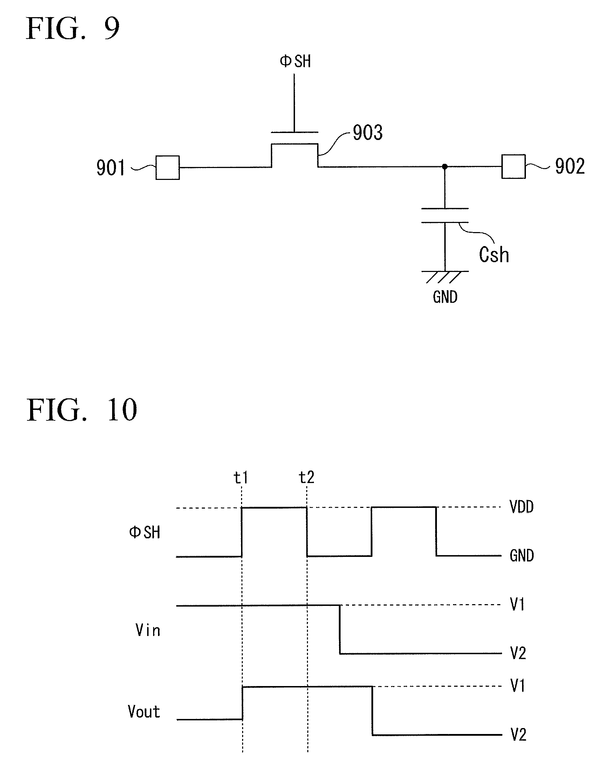

As an example of a sample and hold circuit for sampling and holding an analog signal, a sample and hold circuit shown in Fig. 9 is known conventionally. Fig. 9 shows a configuration of the conventional sample and hold circuit. First, the configuration of the sample and hold circuit shown in Fig. 9 will be described.

The sample and hold circuit shown in Fig. 9 includes an input terminal 901, an output terminal 902, a switching circuit 903, and a capacitor Csh. The input terminal 901 is connected to an input of the switching circuit 903. An output of the switching circuit 903 is connected to the output terminal 902 and one end of the capacitor Csh. The other end of the capacitor Csh is connected to ground GND. The switching circuit 903 and the capacitor Csh are formed in a semiconductor substrate.

A control signal ΦSH is input to the switching circuit 903. When the control signal ΦSH is in a High state (logical value "1"), the switching circuit 903 is in an ON state (conductive state) in which an electric current is applied to an input and an output. In addition, when the control signal ΦSH is in a Low state (logical value "0"), the switching circuit 903 is in an OFF state (non-conductive state) in which no electric current is applied to an input and an output (the input and output are disconnected).

Next, an operation of the sample and hold circuit shown in Fig. 9 will be described using Fig. 10. Fig. 10 shows waveforms of signals (a control signal ΦSH, an analog signal Vin, and an analog signal Vout) related to the sample and hold circuit shown in Fig. 9. A horizontal axis direction of Fig. 10 represents time and a vertical axis direction of Fig. 10 represents voltage.

The analog signal Vin input from the input terminal 901 is input to the switching circuit 903. When the sample and hold circuit samples the input analog signal Vin, the control signal ΦSH is in the High state, so that the switching circuit 903 is in the ON state. At this time, the sample and hold circuit charges the capacitor Csh through the analog signal Vin (timing t1 of Fig. 10). When the sample and hold circuit holds the input analog signal Vin, the control signal ΦSH is in the Low state, so that the switching circuit 903 is in the OFF state. At this time, the sample and hold circuit holds the analog signal Vin in the capacitor Csh (timing t2 of Fig. 10). The analog signal Vout held in the capacitor Csh is output from the output terminal 902 as an output signal. The analog signal Vout held in the capacitor Csh is constant while the control signal ΦSH is in the Low state.

[Summary of Invention]

[Technical Problem]

However, the above-described conventional sample and hold circuit has the following problems. Deviation (crosstalk) is likely to occur in the analog signal Vout held by the capacitor Csh resulting from a voltage of the analog signal Vout held by the capacitor Csh and a voltage of the analog signal Vin input to the switching circuit 903 while the capacitor Csh holds the analog signal Vout. This is because capacitance (parasitic capacitance) formed between the input and output of the switching circuit 903 has an influence even when the control signal ΦSH is in the Low state in the switching circuit 903 formed in the semiconductor substrate.

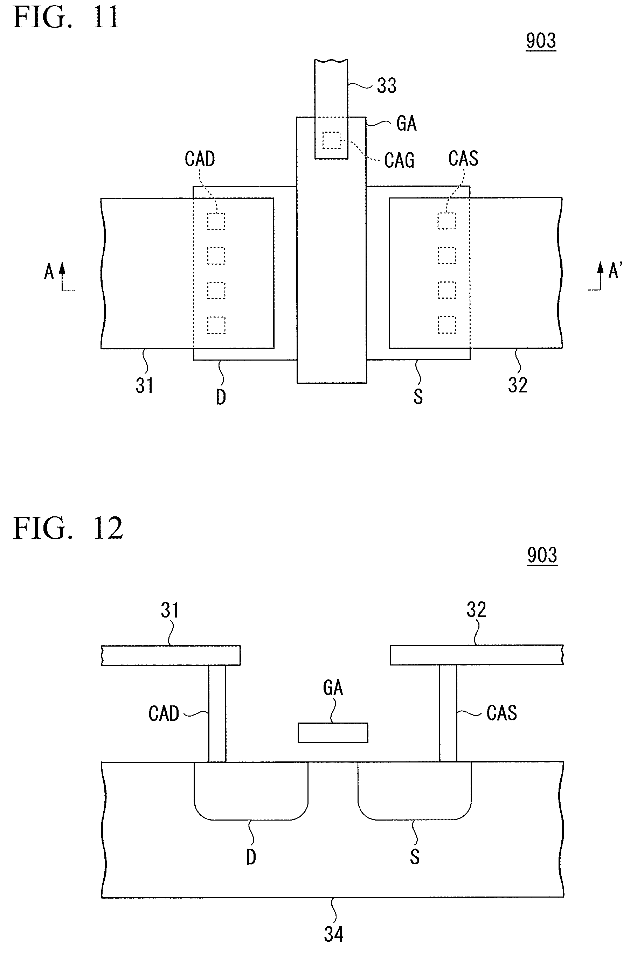

Hereinafter, the case in which the deviation occurs in the analog signal Vout held by the capacitor Csh will be described. Fig. 11 shows a layout of the switching circuit 903. In Fig. 11, a state in which the switching circuit 903 is two-dimensionally viewed in a direction perpendicular to a main surface of the semiconductor substrate constituting the switching circuit 903 (the main surface of the semiconductor substrate is viewed from above) is shown. Fig. 12 shows a cross-sectional structure along line A-A' of Fig. 11. The switching circuit 903 includes a drain wiring 31, a source wiring 32, a gate wiring 33, a drain region D, a source region S, a gate electrode GA, a drain contact CAD, a source contact CAS, and a gate contact CAG.

A P-type single crystal substrate (P-type Si substrate 34 of Fig. 12) is used in a semiconductor substrate serving as a base of the switching circuit 903. The switching circuit 903 is formed in an N-channel metal-oxide semiconductor (NMOS) transistor. The gate electrode GA formed of polysilicon is formed on the P-type Si substrate 34. The gate electrode GA is connected to the gate wiring 33 via the gate contact CAG. The drain region D is connected to the drain wiring 31 via the drain contact CAD. The source region S is connected to the source wiring 32 via the source contact CAS. In addition, a position at which the gate electrode GA, each contact, and each wiring are not formed above the P-type Si substrate 34 is an insulation layer INS.

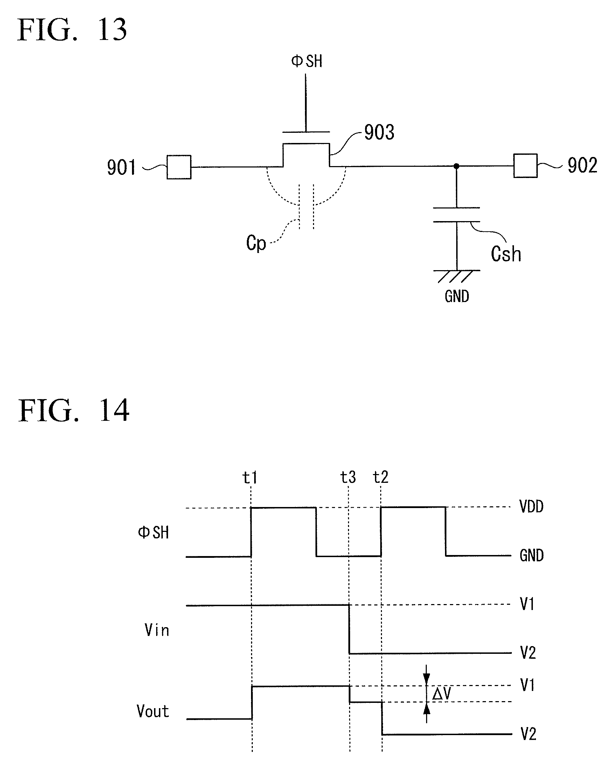

In the switching circuit 903 of the above-described configuration, parasitic capacitance Cp is formed between the drain wiring 31 and the source wiring 32 (between the input and output of the switching circuit 903). Fig. 13 shows a configuration of a sample and hold circuit in which the parasitic capacitance Cp is formed. In addition, Fig. 14 shows waveforms of signals (a control signal ΦSH, an analog signal Vin, and an analog signal Vout) related to the sample and hold circuit shown in Fig. 13. A horizontal axis direction of Fig. 14 represents time and a vertical axis direction of Fig. 14 represents voltage.

In the sample and hold circuit shown in Fig. 13, the parasitic capacitance Cp is present. Thus, despite the fact that the control signal ΦSH is in the Low state, the deviation (crosstalk) of ΔV occurs in the voltage held by the capacitor Csh according to a difference between a voltage Vo of the analog signal Vout held by the capacitor Csh and a voltage Vi of the analog signal Vin input to the switching circuit 903 while the capacitor Csh holds the analog signal Vout (timing t3 of Fig. 14). Here, when a value of the capacitor Csh is defined as C1 and a value of the parasitic capacitance Cp is defined as C2, ΔV can be represented by the following Formula (1).

[Math 1]

$$\Delta V = \frac{C2}{C1 + C2} \times \left(Vi - Vo\right) \qquad \cdots \;\; (1)$$

The above-described voltage deviation ΔV may be problematic for output characteristics of an analog circuit. As one specific example, a solid-state imaging device mounted on a distal end of an endoscope is considered. It is necessary to reduce the size of the solid-state imaging device to mount the solid-state imaging device on the distal end of a narrow endoscope. Thus, it is difficult to sufficiently increase the value of the capacitor Csh due to constraints on a circuit area.

As an example of specific numeric values, assuming that C1 = 1 pF, C2=1 fF, Vo = 2 V, and Vi = 1 V in Formula (1), an error of ΔV ≈ -1 mV occurs. When the resolution of the AD conversion circuit provided in a subsequent stage of the sample and hold circuit is designated as 12 bits and the input voltage range of the AD conversion circuit is designated as 1 V, an error of 1 mV at the input voltage is likely to be an error of about 4 least significant bits (LSBs) in data after analog-to-digital (AD) conversion.

The present invention has been made in view of the above-described problems, and an objective of the invention is to provide a switching circuit, a sample and hold circuit, and a solid-state imaging device capable of reducing the deviation (crosstalk) of a voltage value while a voltage is held.

[Solution to Problem]

According to a first aspect of the present invention, a switching circuit includes: a semiconductor layer including a source region, a drain region, and a channel region disposed between the source region and the drain region; a gate electrode disposed to be opposite to the channel region; a source wiring formed of a first material having higher conductivity than the semiconductor layer and connected to the source region; a drain wiring formed of a second material having higher conductivity than the semiconductor layer and connected to the drain region; and a decoupling wiring formed of a third material having higher conductivity than the semiconductor layer and disposed between the source wiring and the drain wiring, wherein the source region and the drain region are in a conductive state in a first period according to a voltage of the gate electrode and the source region and the drain region are in a non-conductive state in a second period different from the first period, wherein the voltage of the source wiring or the drain wiring changes in the second period, and wherein the voltage of the decoupling wiring is constant in the second period.

According to a second aspect of the present invention, in the switching circuit according to the first aspect, the first material, the second material, and the third material may be the same material.

According to a third aspect of the present invention, in the switching circuit according to the first aspect, the decoupling wiring may be connected to the gate electrode and supply a gate voltage to the gate electrode.

According to a fourth aspect of the present invention, in the switching circuit according to the first or second aspect, the decoupling wiring may be disposed not to overlap the gate electrode when the semiconductor layer is viewed in a direction perpendicular to a main surface of a semiconductor substrate including the semiconductor layer.

According to a fifth aspect of the present invention, a sample and hold circuit includes: the switching circuit according to the first aspect; an input terminal; an output terminal; and a capacitor, wherein one of the source wiring and the drain wiring is connected to the input terminal, wherein the other of the source wiring and the drain wiring is connected to the output terminal, and wherein the capacitor is connected between the output terminal and a point having a predetermined constant voltage.

According to a sixth aspect of the present invention, in the sample and hold circuit according to the fifth aspect, second parasitic capacitance formed between the other of the source wiring and the drain wiring connected to the output terminal and the decoupling wiring may be less than first parasitic capacitance formed between the one of the source wiring and the drain wiring connected to the input terminal and the decoupling wiring.

According to a seventh aspect of the present invention, a solid-state imaging device includes: an imaging unit in which a plurality of pixels, each of which outputs a pixel signal according to an amount of incident light, are disposed in a matrix shape; and the sample and hold circuit according to the fifth aspect configured to sample and hold an analog signal resulting from the pixel signal.

[Advantageous Effects of Invention]

According to the present invention, parasitic capacitance is unlikely to be formed between a source wiring and a drain wiring because a decoupling wiring is disposed between the source wiring and the drain wiring. Thus, it is possible to reduce the deviation (crosstalk) of a voltage value while a voltage is held.

[Brief Description of Drawings]

Fig. 1 is a top view of a switching circuit according to a first embodiment of the present invention.
Fig. 2 is a cross-sectional view of the switching circuit according to the first embodiment of the present invention.
Fig. 3 is a circuit diagram showing a peripheral configuration of the switching circuit according to the first embodiment of the present invention.
Fig. 4 is a timing chart showing waveforms of signals related to the switching circuit according to the first embodiment of the present invention.
Fig. 5 is a top view of a switching circuit according to a second embodiment of the present invention.
Fig. 6 is a top view of a switching circuit according to a third embodiment of the present invention.
Fig. 7 is a circuit diagram showing a configuration of a sample and hold circuit according to a fourth embodiment of the present invention.
Fig. 8 is a block diagram showing a configuration of a solid-state imaging device according to a fifth embodiment of the present invention.
Fig. 9 is a circuit diagram showing a configuration of a conventional sample and hold circuit.
Fig. 10 is a timing chart showing waveforms of signals related to the conventional sample and hold circuit.
Fig. 11 is a top view of a switching circuit constituting the conventional sample and hold circuit.
Fig. 12 is a cross-sectional view of the switching circuit constituting the conventional sample and hold circuit.
Fig. 13 is a circuit diagram showing a configuration of the conventional sample and hold circuit.
Fig. 14 is a timing chart showing waveforms of signals related to the conventional sample and hold circuit.

[Description of Embodiments]

Hereinafter, embodiments of the present invention will be described with reference to the drawings.

(First embodiment)

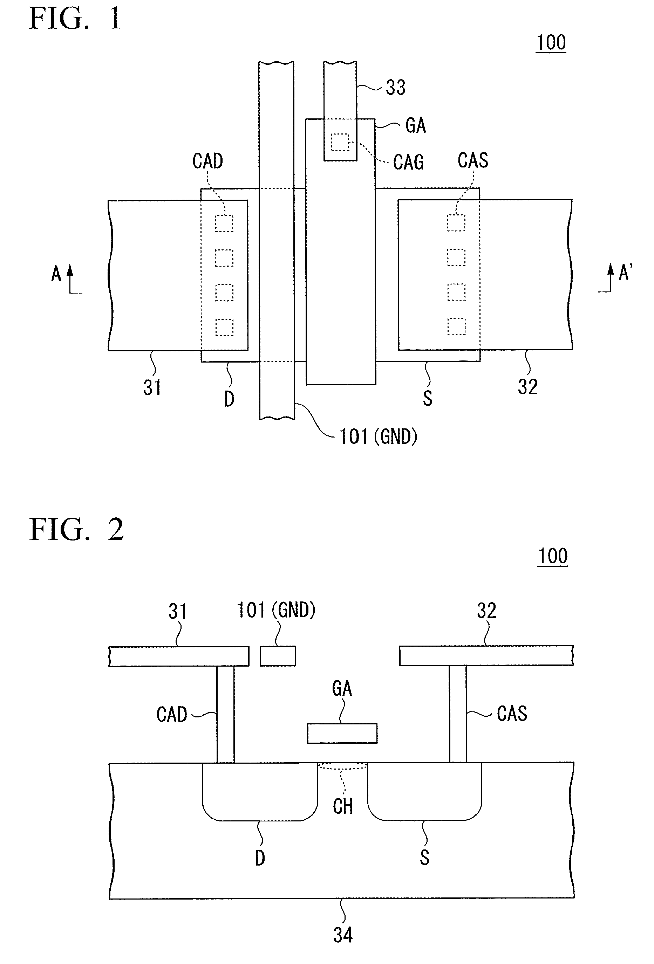

First, the first embodiment of the present invention will be described. Fig. 1 shows a configuration of a switching circuit 100 which is an example of a switching circuit according to this embodiment. In Fig. 1, a state in which the switching circuit 100 is two-dimensionally viewed in a direction perpendicular to a main surface of a semiconductor substrate constituting the switching circuit 100 (the main surface of the semiconductor substrate is viewed from the above) is shown. Fig. 2 shows a cross-sectional structure along line A-A' of Fig. 1. The switching circuit 100 includes a drain wiring 31, a source wiring 32, a gate wiring 33, a decoupling wiring 101, a drain region D, a source region S, a gate electrode GA, a drain contact CAD, a source contact CAS, and a gate contact CAG.

A P-type Si substrate 34 is used in a semiconductor substrate serving as a base of the switching circuit 100. The switching circuit 100 is formed in an NMOS transistor. The P-type Si substrate 34 is a semiconductor layer including a source region S, a drain region D, and a channel region CH disposed between the source region S and the drain region D. The source region S and the drain region D are regions having different impurity concentrations from the P-type Si substrate 34. The source region S is exposed on the surface of the P-type Si substrate 34 and connected to the source contact CAS. The drain region D is exposed on the surface of the P-type Si substrate 34 and connected to the drain contact CAD. The channel region CH is disposed in the vicinity of the surface of the P-type Si substrate 34. During the operation of the switching circuit 100, a channel serving as a path of an electric current is formed in the channel region CH.

The gate electrode GA constituted of polysilicon is formed on the P-type Si substrate 34. The gate electrode GA is disposed to be opposite to the channel region CH. In addition, the gate electrode GA is connected to the gate wiring 33 formed in a first metal layer via the gate contact CAG. The drain region D is connected to the drain wiring 31 formed in the first metal layer via the drain contact CAD. The source region S is connected to the source wiring 32 formed in the first metal layer via the source contact CAS.

The gate wiring 33 is disposed not to overlap the channel region CH when the switching circuit 100 is two-dimensionally viewed in a direction perpendicular to a main surface of the P-type Si substrate 34 (the main surface of the semiconductor substrate is viewed from above) in the example shown in Fig. 1. The drain wiring 31 extends in a direction (left in Fig. 1) opposite to that in which the source wiring 32 is disposed when viewed from the position of the drain wiring 31. The source wiring 32 extends in a direction (right in Fig. 1) opposite to that in which the drain wiring 31 is disposed when viewed from the position of the source wiring 32.

A position at which the gate electrode GA, each contact, and each wiring are not formed above the P-type Si substrate 34 is an insulation layer INS formed of an insulation material. That is, the insulation layer INS is disposed to internally include the source region S, the drain region D, and the gate electrode GA. The source wiring 32 is formed of a first material having higher conductivity than the P-type Si substrate 34 which is a semiconductor layer and connected to the source region S. The drain wiring 31 is formed of a second material having higher conductivity than the P-type Si substrate 34 which is the semiconductor layer and connected to the drain region D.

In Fig. 1, four drain contacts CAD and four source contacts CAS are disposed. When the number of drain contacts CAD and the number of source contacts CAS increase, parasitic capacitance is formed between the drain contact CAD and the source contact CAS. Thus, it is preferable that each of the number of drain contacts CAD and the number of source contacts CAS be one or two or more and only a minimum number of drain contacts CAD and that a minimum number of source contacts CAS capable of securing the yield in a semiconductor manufacturing process be disposed.

In addition, the switching circuit 100 has the decoupling wiring 101 in the first metal layer in which the drain wiring 31, the source wiring 32, and the gate wiring 33 are formed. That is, the drain wiring 31, the source wiring 32, the gate wiring 33, and the decoupling wiring 101 are formed in the same layer. The decoupling wiring 101 is formed of a third material having higher conductivity than the P-type Si substrate 34 which is the semiconductor layer and disposed between the source wiring 32 and the drain wiring 31. Therefore, the decoupling wiring 101 is opposite to the source wiring 32 and is opposite to the drain wiring 31.

The decoupling wiring 101 is disposed on the drain region D and connected to the ground GND. In addition, the decoupling wiring 101 is disposed not to overlap the gate electrode GA when the P-type Si substrate 34 which is the semiconductor layer is two-dimensionally viewed in a direction perpendicular to the main surface of the P-type Si substrate 34 (the main surface of the semiconductor substrate is viewed from above).

The first material constituting the source wiring 32, the second material constituting the drain wiring 31, and the third material constituting the decoupling wiring 101 are the same material (for example, a metal) in the example of this embodiment. One or more of these materials may be a different material. That is, the first material may be the same as only one of the second and third materials, may be the same as both the second and third materials, or may be different from both of the second and third materials. The same is also true for the second material and the third material.

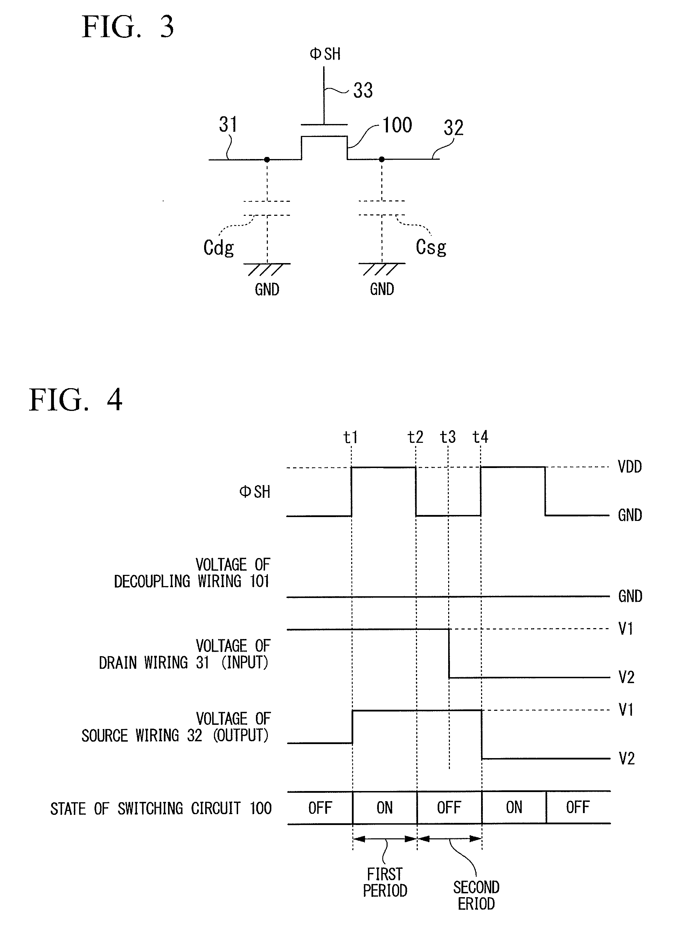

Fig. 3 shows a peripheral configuration of the switching circuit 100 configured as described above. When the analog signal is input to the drain wiring 31, the switching circuit 100 outputs the analog signal to the source wiring 32. The control signal $\Phi$SH is input to the gate wiring 33. When the control signal $\Phi$SH is in a High state (logical value "1"), a channel is formed in the channel region CH below the gate electrode GA and the switching circuit 100 is in an ON state (conductive state) in which an electric current is applied to the drain region D (input) and the source region S (output). In addition, when the control signal $\Phi$SH is in a Low state (logical value "0"), the channel of the channel region CH below the gate electrode GA is lost and an OFF state (non-conductive state) in which no electric current is applied to the drain region D (input) and the source region S (output) (the drain region D (input) and the source region S (output) are disconnected) occurs.

In the switching circuit 100, first parasitic capacitance Cdg is formed between the drain wiring 31 and the ground GND through the drain wiring 31 and the decoupling wiring 101 connected to the ground GND. Likewise, in the switching circuit 100, second parasitic capacitance Csg is formed between the source wiring 32 and the ground GND through the source wiring 32 and the decoupling wiring 101 connected to the ground GND.

Next, an operation of this embodiment will be described. Fig. 4 shows waveforms of signals (a control signal $\Phi$SH, a voltage of the decoupling wiring 101, a voltage of the drain wiring 31, and a voltage of the source wiring 32) related to the switching circuit 100. A horizontal axis direction of Fig. 4 represents time and a vertical axis direction of Fig. 4 represents voltage. In addition, in Fig. 4, the states (ON and OFF states) of the switching circuit 100 are shown.

First, the control signal ΦSH changes from the Low state (logical value "0") to the High state (logical value "1"), so that the switching circuit 100 is in the ON state in which the electric current is applied to the drain region D (input) and the source region S (output) (timing t1 of Fig. 4). Thereby, the voltage of the source wiring 32 which is the output of the switching circuit 100 becomes a voltage V1 equal to the voltage of the drain wiring 31 which is an input of the switching circuit 100. Thereafter, in a predetermined period (first period), the control signal ΦSH is in the High state (logical value "1") and the switching circuit 100 is in the ON state.

After the first period has elapsed, the control signal ΦSH changes from the High state (logical value "1") to the Low state (logical value "0"), so that the switching circuit 100 is in the OFF state in which no electric current is applied to the drain region D (input) and the source region S (output) (the drain region D (input) and the source region S (output) are disconnected) (timing t2 of Fig. 4). Thereafter, in a predetermined period (second period), the control signal ΦSH is in the Low state (logical value "0") and the switching circuit 100 is in the OFF state.

When the switching circuit 100 is in the OFF state in the example shown in Fig. 4, the voltage of the drain wiring 31 which is the input of the switching circuit 100 changes from a voltage V1 to a voltage V2 (timing t3 of Fig. 4). At this time, no electric current is applied to the drain region D (input) and the source region S (output) of the switching circuit 100 and there is no parasitic capacitance between the drain wiring 31 and the source wiring 32. Thus, the voltage of the source wiring 32 remains at the voltage V2 and no deviation occurs in the voltage value.

After the second period has elapsed, the control signal ΦSH changes from the Low state (logical value "0") to the High state (logical value "1 "), so that the switching circuit 100 is in the ON state in which the electric current is applied to the drain region D (input) and the source region S (output) (timing t4 of Fig. 4). Thereby, the voltage of the source wiring 32 which is the output of the switching circuit 100 becomes the voltage V2 equal to the voltage of the drain wiring 31 which is an input of the switching circuit 100. Because the decoupling wiring 101 is connected to the ground GND, the voltage of the decoupling wiring 101 is constant at the ground GND.

That is, in the example shown in Fig. 4, according to the voltage of the gate electrode GA, the source region S and the drain region D are in the ON state (conductive state) in a first period and the source region S and the drain region D are in the OFF state (non-conductive state) in a second period different from the first period. In addition, the voltage of the source wiring 32 or the drain wiring 31 (the voltage of the drain wiring 31 in the example shown in Fig. 4) changes in the second period and the voltage of the decoupling wiring 101 is constant in the second period.

Because the decoupling wiring 101 is disposed between the drain wiring 31 and the source wiring 32 according to the configuration shown in Fig. 1 as described above, parasitic capacitance is unlikely to be formed between the drain wiring 31 and the source wiring 32. Thus, it is possible to reduce the deviation (crosstalk) of the voltage value even when the switching circuit 100 is in the OFF state and the input voltage changes while the output voltage is held.

Although the voltage connected to the decoupling wiring 101 is the ground GND in this embodiment, the present invention is not limited thereto. For example, the voltage connected to the decoupling wiring 101 may be a power supply voltage or a predetermined constant voltage other than the ground GND or the power supply voltage. In addition, if a change time (frequency) of the voltage of the decoupling wiring 101 is sufficiently long (delayed) as compared with the second period, the voltage connected to the decoupling wiring 101 may not be a constant voltage.

In addition, although the decoupling wiring 101 is disposed on the drain region D in this embodiment, the present invention is not limited thereto. For example, the decoupling wiring 101 may be disposed on the source region S or the gate electrode GA.

In addition, although the switching circuit 100 is an NMOS transistor in this embodiment, the present invention is not limited thereto. For example, the switching circuit 100 may be constituted of a P-channel metal-oxide semiconductor (PMOS) transistor or a combination of the NMOS transistor and the PMOS transistor. When the switching circuit 100 is constituted of the PMOS transistor, the operation (state) of the switching circuit 100 for the control signal ΦSH is opposite to the operation (state) of the case in which the switching circuit 100 is constituted of the NMOS transistor, but the same effect is obtained. For example, according to the voltage of the gate voltage, the source region and the drain region are in the ON state (conductive state) in the first period and the source region and the drain region are in the OFF state (non-conductive state) in the second period different from the first period. In addition, the voltage of the source wiring changes in the second period and the voltage of the decoupling wiring 101 is constant in the second period.

In addition, although the switching circuit 100 is configured to have the drain region D as the input and the source region S as the output in this embodiment, the present invention is not limited thereto. For example, the switching circuit 100 may be configured to have the source region S as the input and the drain region D as the output.

In addition, although the metal layer constituting the wiring of the switching circuit 100 is only the first metal layer in this embodiment, the present invention is not limited thereto. In the semiconductor manufacturing process, a plurality of metal layers are generally provided. When the drain wiring and the source wiring are also formed in a second metal layer one layer above the first metal layer or a higher metal layer, it is only necessary to form the decoupling wiring in the same metal layer as the drain wiring and the source wiring.

(Second embodiment)

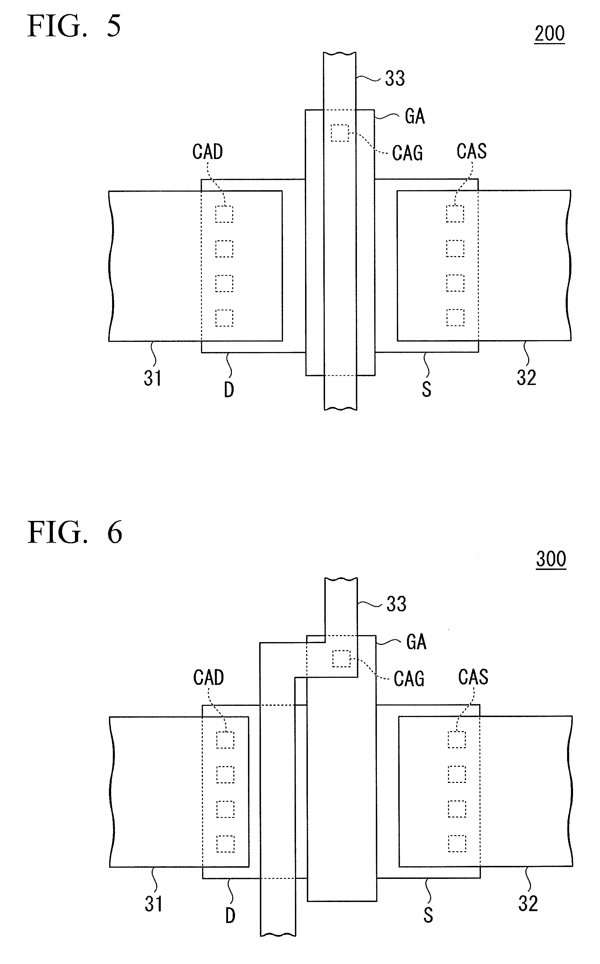

Next, the second embodiment of the present invention will be described. Fig. 5 shows a configuration of a switching circuit 200 which is an example of a switching circuit according to this embodiment. In Fig. 5, a state in which the switching circuit 200 is two-dimensionally viewed in a direction perpendicular to a main surface of a semiconductor substrate constituting the switching circuit 200 (the main surface of the semiconductor substrate is viewed from above) is shown. The same components as those used in Fig. 1 among components used in Fig. 5 are assigned the same reference signs and a description thereof will be omitted. Hereinafter, the configuration and operation of this embodiment will be described based on differences from the first embodiment.

The configuration shown in Fig. 5 is different from that shown in Fig. 1 in that a gate wiring 33 is wired below a gate electrode GA and disposed between a drain wiring 31 and a source wiring 32. The gate wiring 33 is opposite to both the drain wiring 31 and the source wiring 32. Through this configuration, the gate wiring 33 can also have a function of a decoupling wiring and it is unnecessary to dispose a separate decoupling wiring. That is, the decoupling wiring of this embodiment is the same as the gate wiring 33 and is connected to the gate electrode GA and a gate voltage (a voltage of a control signal $\Phi$SH) is supplied to the gate electrode GA.

Next, the operation of this embodiment will be described. The operation of this embodiment is the same as the operation shown in Fig. 4 in the first embodiment. That is, because the voltage of the gate wiring 33 functioning as the decoupling wiring is constant in the second period, the voltage of the source wiring 32 remains at a voltage V2 and no deviation occurs in the voltage value.

Because the gate wiring 33 also has the decoupling wiring according to the configuration shown in Fig. 5 as described above, it is unnecessary to separately dispose the wiring of ground GND or a power supply voltage to be used as the decoupling wiring. Thus, a layout can be simplified.

In addition, although the switching circuit 200 is an NMOS transistor in this embodiment, the present invention is not limited thereto. For example, the switching circuit 200 may be constituted of a PMOS transistor or a combination of the NMOS transistor and the PMOS transistor. When the switching circuit 200 is constituted of the PMOS transistor, the operation (state) of the switching circuit 200 for the control signal $\Phi$SH is opposite to the operation (state) of the case in which the switching circuit 200 is constituted of the NMOS transistor, but the same effect is obtained. For example, according to the voltage of the gate voltage, the source region and the drain region are in the ON state (conductive state) in the first period and the source region and the drain region are in the OFF state (non-conductive state) in the second period different from the first period. In addition, the voltage of the source wiring changes in the second period and the voltage of the decoupling wiring 101 is constant in the second period.

In addition, although the switching circuit 200 is configured to have a drain region D as an input and a source region S as an output in this embodiment, the present invention is not limited thereto. For example, the switching circuit 200 may be configured to have the source region S as the input and the drain region D as the output.

In addition, although a metal layer constituting the wiring of the switching circuit 200 is only a first metal layer in this embodiment, the present invention is not limited thereto. In a semiconductor manufacturing process, a plurality of metal layers are generally provided. When the drain wiring and the source wiring are also formed in a second metal layer one layer above the first metal layer or a higher metal layer, it is only necessary to form the decoupling wiring in the same metal layer as the drain wiring and the source wiring.

(Third embodiment)

Next, the third embodiment of the present invention will be described. Fig. 6 shows a configuration of a switching circuit 300 which is an example of a switching circuit according to this embodiment. The same components as those used in Fig. 5 among components used in Fig. 6 are assigned the same reference signs and a description thereof will be omitted. Hereinafter, the configuration and operation of this embodiment will be described based on differences from the second embodiment.

In the configuration shown in Fig. 6, a difference from the configuration shown in Fig. 5 is a layout of a gate wiring 33. Specifically, the gate wiring 33 is perpendicularly bent to the left (the side of a drain region D) at a position of a gate contact CAG and wired below the drain region D through the upper portion of the drain region D. That is, in this embodiment, the gate wiring 33 is disposed on the drain region D without being disposed on a gate electrode GA. Even in this embodiment, the gate wiring 33 is opposite to both a drain wiring 31 and a source wiring 32.

Because an operation of this embodiment is the same as those of the above-described first and second embodiments, a description thereof will be omitted.

Because a transistor characteristic (threshold voltage) is different from the case in which no wiring is disposed on a channel in a semiconductor manufacturing process when the wiring is disposed on the channel, a characteristic at the time of design may not be secured. However, because no wiring is disposed on the channel according to the configuration shown in Fig. 6, no deviation occurs in the transistor characteristic (threshold voltage) in the semiconductor manufacturing process and the characteristic at the time of design can be secured.

Although the gate wiring 33 is disposed on the drain region D in this embodiment, the present invention is not limited thereto. For example, the gate wiring 33 may be disposed on the source region S.

In addition, although the switching circuit 300 is an NMOS transistor in this embodiment, the present invention is not limited thereto. For example, the switching circuit 300 may be constituted of a PMOS transistor or a combination of the NMOS transistor and the PMOS transistor. When the switching circuit 300 is constituted of the PMOS transistor, the operation (state) of the switching circuit 300 for the control signal ΦSH is opposite to the operation (state) of the case in which the switching circuit 300 is constituted of the NMOS transistor, but the same effect is obtained. For example, according to the voltage of the gate voltage, the source region and the drain region is in the ON state (conductive state) in the first period and the source region and the drain region are in the OFF state (non-conductive state) in the second period different from the first period. In addition, the voltage of the source wiring changes in the second period and the voltage of the decoupling wiring 101 is constant in the second period.

In addition, although the switching circuit 300 is configured to have the drain region D as an input and a source region S as an output in this embodiment, the present invention is not limited thereto. For example, the switching circuit 200 may be configured to have the source region S as the input and the drain region D as the output.

In addition, although a metal layer constituting the wiring of the switching circuit 300 is only a first metal layer, the present invention is not limited thereto. In the semiconductor manufacturing process, a plurality of metal layers are generally provided. When the drain wiring and the source wiring are also formed in a second metal layer one layer above the first metal layer or a higher metal layer, it is only necessary to form the decoupling wiring in the same metal layer as the drain wiring and the source wiring.

(Fourth embodiment)

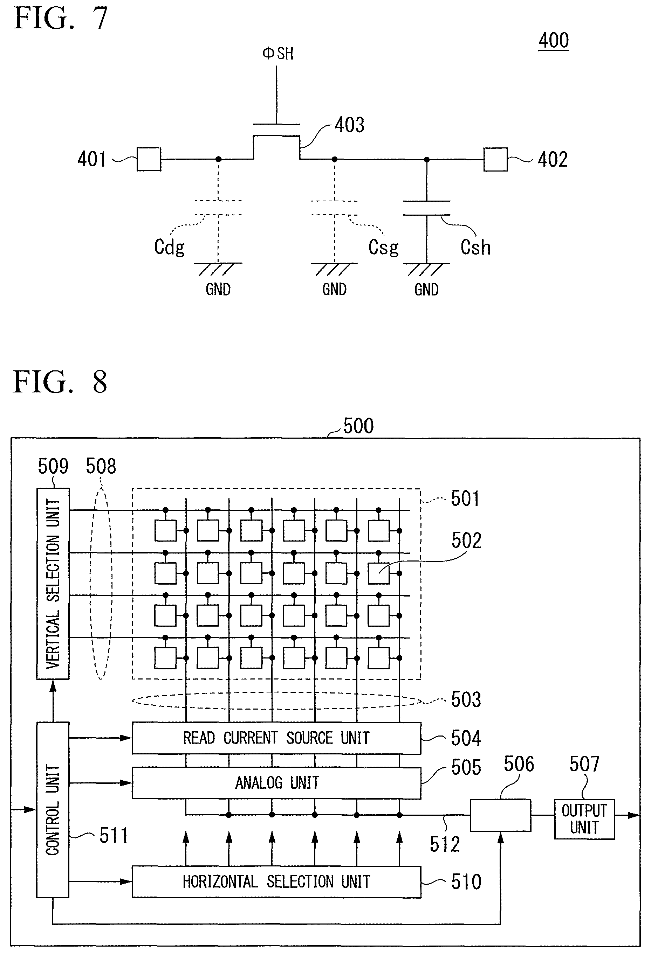

Next, the fourth embodiment of the present invention will be described. Fig. 7 shows a configuration of a sample and hold circuit 400 which is an example of a sample and hold circuit according to this embodiment. Hereinafter, the configuration of this example will be described.

The sample and hold circuit 400 shown in Fig. 7 includes an input terminal 401, an output terminal 402, a switching circuit 403, and a capacitor Csh. The input terminal 401 is connected to an input of the switching circuit 403. An output of the switching circuit 403 is connected to the output terminal 402 and one end of the capacitor Csh. The other end of the capacitor Csh is connected to ground GND. The switching circuit 403 and the capacitor Csh are formed in a semiconductor substrate.

The switching circuit 403 is constituted of the switching circuit according to any one of the above-described first to third embodiments. Accordingly, the sample and hold circuit 400 of this embodiment has the switching circuit 403, the input terminal 401, the output terminal 402, and the capacitor Csh. One of the source wiring and the drain wiring (the drain wiring in the example shown in Fig. 7) is connected to the input terminal 401. The other of the source wiring and the drain wiring (the source wiring in the example shown in Fig. 7) is connected to the output terminal 402. The capacitor Csh is connected between the output terminal 402 and a point (the ground GND in the example shown in Fig. 7) having a predetermined constant voltage.

Because the decoupling wiring is disposed between the drain wiring and the source wiring in the switching circuit 403, parasitic capacitance is unlikely to be formed between the drain wiring and the source wiring. A control signal ΦSH is input to the switching circuit 403. When the control signal ΦSH is in a High state (logical value "1"), the switching circuit 403 is in an ON state (conductive state) in which an electric current is applied to an input and an output. In addition, when the control signal ΦSH is in a Low state (logical value "0"), the switching circuit 403 is in an OFF state (non-conductive state) in which no electric current is applied to an input and an output (the input and output are disconnected).

In the example shown in Fig. 7, the switching circuit 403 is constituted of the switching circuit 100 according to the first embodiment. Because the drain wiring is opposite to the decoupling wiring connected to the ground GND in the switching circuit 403, first parasitic capacitance Cdg is formed between the drain wiring and the ground GND. Likewise, because the source wiring is opposite to the decoupling wiring connected to the ground GND in the switching circuit 403, second parasitic capacitance Csg is formed between the source wiring and the ground GND.

Because the drain wiring is opposite to the decoupling wiring connected to the gate electrode in the switching circuit 403 when the switching circuit 403 is constituted of the switching circuit 200 according to the second embodiment or the switching circuit 300 according to the third embodiment, the first parasitic capacitance Cdg is formed between the drain wiring and the gate voltage. Likewise, because the source wiring is opposite to the decoupling wiring connected to the gate voltage in the switching circuit 403, second parasitic capacitance Csg is formed between the source wiring and the gate voltage.

Because an operation of this embodiment is the same as those of the above-described first to third embodiments, a description thereof will be omitted.

As described above, according to the configuration shown in Fig. 7, the switching circuit 403 has the decoupling wiring, so that parasitic capacitance is unlikely to be formed between the source wiring and the drain wiring. Thus, a value C2 of parasitic capacitance Cp is substantially 0 in Formula (1), $\Delta V \approx 0$. That is, it is possible to reduce the deviation (crosstalk) of a voltage value while the capacitor Csh maintains a voltage.

When the gate wiring (decoupling wiring) of the switching circuit 403 is not disposed on the gate electrode (the case of the third embodiment) in this embodiment, the gate wiring (decoupling wiring) is disposed on an input side (on the drain region D in Fig. 6 of the third embodiment), so that the second parasitic capacitance Csg can be configured to be less than the first parasitic capacitance Cdg. Thus, it is possible to reduce an increase of an output load (a sum of the capacitance of the capacitor Csh and the second parasitic capacitance Csg) of the sample and hold circuit 400.

The gate wiring (decoupling wiring) is disposed on the input side as described above, so that the second parasitic capacitance Csg formed between the other wiring of the source wiring and the drain wiring connected to the output terminal 402 and the decoupling wiring is less than the first parasitic capacitance Cdg formed between one of the source wiring and the drain wiring connected to the input terminal 401 and the decoupling wiring.

Disposing the gate wiring (decoupling wiring) on the input side is an example of a method of setting the second parasitic capacitance Csg less than the first parasitic capacitance Cdg. For example, it is possible to set the second parasitic capacitance Csg less than the first parasitic capacitance Cdg by setting the distance between mutually opposite sides of the gate wiring (decoupling wiring) and the wiring (drain wiring) of the input side less than the distance between mutually opposite sides of the gate wiring (decoupling wiring) and the wiring (source wiring) of the output side. Alternatively, when the distance between the gate wiring (decoupling wiring) and the wiring (drain wiring) of the input side is substantially the same as the distance between the gate wiring (decoupling wiring) and the wiring (source wiring) of the output side, a length of a side of the wiring (drain wiring) of the input side opposite to the gate wiring (decoupling wiring) is configured to be longer than a length of a side of the wiring (source wiring) of the output side opposite to the gate wiring (decoupling wiring), the second parasitic capacitance Csg can be configured to be less than the first parasitic capacitance Cdg.

In addition, although the capacitor Csh is connected to the output terminal 402 and the ground GND in this embodiment, the present invention is not limited thereto. For example, the capacitor Csh may be connected between the output terminal 402 and the power supply voltage or the capacitor Csh may be connected between the output terminal 402 and a point having a predetermined constant voltage other than the ground GND or the power supply voltage.

In addition, although the switching circuit 403 is configured to have the drain region D as an input and the source region S as an output in this embodiment, the present invention is not limited thereto. For example, the switching circuit 403 may be configured to have the source region S as the input and the drain region D as the output.

(Fifth embodiment)

Next, the fifth embodiment of the present invention will be described. Fig. 8 shows a configuration of a solid-state imaging device 500 which is an example of a solid-state imaging device according to this embodiment. The solid-state imaging device 500 shown in Fig. 8 includes an imaging unit 501, a read current source unit 504, an analog unit 505, a sample and hold unit 506, an output unit 507, a vertical selection unit 509, a horizontal selection unit 510, and a control unit 511.

In the imaging unit 501, a plurality of pixels (unit pixels 502), each of which generates and outputs a pixel signal according to an amount of incident light, are disposed. The vertical selection unit 509 selects each row of the imaging unit 501. The read current source unit 504 reads the pixel signal from the imaging unit 501 as a voltage signal. The analog unit 505 processes the pixel signal read from the imaging unit 501 and outputs the processed pixel signal. In addition, the analog unit 505 has an auto gain control (AGC) circuit having a signal amplification function and so on, if necessary. The horizontal selection unit 510 transfers the output signal of the analog unit 505 to the sample and hold unit 506 connected to a horizontal signal line 512. The sample and hold unit 506 holds an input signal and outputs the held signal to the output unit 507. The control unit 511 controls each part.

Although the imaging unit 501 including unit pixels 502 of 4 rows×6 columns has been described with reference to Fig. 8 for simplicity, several tens to several tens of thousands of unit pixels 502 are actually arranged in each row or column of the imaging unit 501. Although not shown, the unit pixels 502 constituting the imaging unit 501 include a photoelectric conversion element such as a photodiode, a photo-gate, or a phototransistor and a transistor circuit.

Hereinafter, each part will be described in further detail. The imaging unit 501 includes the unit pixels 502 two-dimensionally disposed in only 4 rows×6 columns. In addition, each row control line 508 is wired for every row in the pixel array of 4 rows×6 columns. One end of each row control line 508 is connected to an output terminal of a corresponding row of the vertical selection unit 509. The vertical selection unit 509 includes a shift register, a decoder, or the like, and controls row addressing and row scanning of the imaging unit 501 through the row control lines 508 when each unit pixel 502 of the imaging unit 501 is driven. In addition, a vertical signal line 503 is wired to each column in the pixel array of the imaging unit 501.

The read current source unit 504 is constituted of a current source for reading the pixel signal from the imaging unit 501 as a voltage signal. The analog unit 505 is constituted of a correlated double sample (CDS) circuit or the like, and processes the read pixel signal from the imaging unit 501 to output the processed pixel signal.

The horizontal selection unit 510 includes a shift register, a decoder, or the like, and controls the column scanning of the analog unit 505. According to the control of the horizontal selection unit 510, the pixel signal processed by the analog unit 505 is sequentially read to the horizontal signal line 512 and transferred to the sample and hold unit 506.

The sample and hold unit 506 is constituted of a sample and hold circuit according to the above-described fourth embodiment, periodically samples and holds an analog signal according to the pixel signal input from the horizontal signal line 512, and outputs the sampled and held analog signal to the output unit 507.

The output unit 507 has a buffering function of outputting the input signal, and outputs a signal to an AD conversion circuit provided in a subsequent stage, although this is not shown. In addition, the output unit 507, for example, may incorporate a signal processing function such as AD conversion circuit or black level adjustment, column variation correction, and color processing in addition to the buffering function.

The control unit 511 includes a functional block of a timing generator (TG), which supplies a clock or a pulse signal of a predetermined timing necessary for an operation of each part such as the vertical selection unit 509, the horizontal selection unit 510, or the sample and hold unit 506, and a functional block for communicating with the TG.

Next, an operation of this embodiment will be described. Although a description of a specific operation of the unit pixel 502 is omitted, a reset level and a signal level are output in the unit pixel 502 as is well known. A reset level including noise of a pixel signal is read in a first read operation as an analog pixel signal from each unit pixel 502 of a selected row of the imaging unit 501, and then a signal level is read in a second read operation. The reset level and the signal level are input to the analog unit 505 through the vertical signal line 503 in time series. The signal level may be read in the first read operation and then the reset level may be read in the second read operation.

The analog unit 505 performs CDS processing on the reset level and the signal level, so that a pixel signal obtained by removing noise from the signal level is generated. Thereafter, the generated pixel signal is output via the sample and hold unit 506 and the output unit 507 sequentially.

As described above, according to the configuration shown in Fig. 8, it is possible to implement a high-quality solid-state imaging device because a sample and hold circuit for reducing the deviation (crosstalk) of the voltage value while the capacitor Csh holds a voltage is disposed.

"Front", "back", "up", "down", "right", "left", "vertical", "horizontal", "below", "lateral", "row", and "column" and other terms expressing directions used in the present description are assumed to represent the orientation of the device of the present invention. Accordingly, the terms in the present description should be relatively interpreted in the device of the present invention.

Although embodiments of the present invention have been described above with reference to the drawings, specific configurations are not limited to the embodiments, and design changes, and so on may also be included without departing from the scope of the present invention.

[Industrial Applicability]

The present invention can be widely applied to a switching circuit, a sample and hold circuit, and a solid-state imaging device. According to the present invention, parasitic capacitance is unlikely to be formed between a source wiring and a drain wiring because a decoupling wiring is disposed between the source wiring and the drain wiring, and it is possible to reduce the deviation (crosstalk) of a voltage value while a voltage is held.

[Reference Signs List]

| | |
|---|---|
| 100, 200, 300, 403, 903 | Switching circuit |
| 31 | Drain wiring |
| 32 | Source wiring |
| 33 | Gate wiring |
| 34 | Semiconductor substrate (semiconductor layer) |
| 101 | Decoupling wiring |
| 400 | Sample and hold circuit |
| 401, 901 | Input terminal |
| 402, 902 | Output terminal |
| 500 | Solid-state imaging device |
| 501 | Imaging unit |
| 504 | Read current source unit |
| 505 | Analog unit |

| 506 | Sample and hold unit |
|---|---|
| 507 | Output unit |
| 509 | Vertical selection unit |
| 510 | Horizontal selection unit |
| 511 | Control unit |
| CH | Channel region |
| D | Drain region |
| S | Source region |
| GA | Gate electrode |
| CAD | Drain contact |
| CAS | Source contact |
| CAG | Gate contact |
| Csh | Capacitor |
| Cdg | First parasitic capacitance |
| Csg | Second parasitic capacitance |

## Claims

1. A switching circuit comprising:

   a semiconductor layer including a source region, a drain region, and a channel region disposed between the source region and the drain region;
   a gate electrode disposed to be opposite to the channel region;
   a source wiring formed of a first material having higher conductivity than the semiconductor layer and connected to the source region;
   a drain wiring formed of a second material having higher conductivity than the semiconductor layer and connected to the drain region; and
   a decoupling wiring formed of a third material having higher conductivity than the semiconductor layer and disposed between the source wiring and the drain wiring,
   wherein the source region and the drain region are in a conductive state in a first period according to a voltage of the gate electrode, and the source region and the drain region are in a non-conductive state in a second period different from the first period,
   wherein a voltage of the source wiring or the drain wiring changes in the second period, and
   wherein a voltage of the decoupling wiring is constant in the second period.

2. The switching circuit according to claim 1, wherein the first material, the second material, and the third material are the same material.

3. The switching circuit according to claim 1, wherein the decoupling wiring is connected to the gate electrode and supplies a gate voltage to the gate electrode.

4. The switching circuit according to claim 1 or 2, wherein, the decoupling wiring is disposed not to overlap the gate electrode when the semiconductor layer is viewed in a direction perpendicular to a main surface of a semiconductor substrate including the semiconductor layer.

5. A sample and hold circuit comprising:

   the switching circuit according to claim 1;
   an input terminal;
   an output terminal; and
   a capacitor,
   wherein one of the source wiring and the drain wiring is connected to the input terminal,
   wherein the other of the source wiring and the drain wiring is connected to the output terminal, and
   wherein the capacitor is connected between the output terminal and a point having a predetermined constant voltage.

6. The sample and hold circuit according to claim 5, wherein second parasitic capacitance formed between the other of the source wiring and the drain wiring connected to the output terminal and the decoupling wiring is less than first parasitic capacitance formed between the one of the source wiring and the drain wiring connected to the input terminal and the decoupling wiring.

7. A solid-state imaging device comprising:

an imaging unit in which a plurality of pixels, each of which outputs a pixel signal according to an amount of incident light, are disposed in a matrix shape; and
the sample and hold circuit according to claim 5 configured to sample and hold an analog signal according to the pixel signal.

**Amended claims under Art. 19.1 PCT**

**1.** Currently Amended)
A switching circuit comprising:

a semiconductor layer including a source region, a drain region, and a channel region disposed between the source region and the drain region;
a gate electrode disposed to be opposite to the channel region;
a source wiring formed of a first material having higher conductivity than the semiconductor layer and connected to the source region;
a drain wiring formed of a second material having higher conductivity than the semiconductor layer and connected to the drain region; and
a decoupling wiring formed of a third material having higher conductivity than the semiconductor layer and disposed between the source wiring and the drain wiring,
wherein the source region and the drain region are in a conductive state in a first period according to a voltage of the gate electrode, and the source region and the drain region are in a non-conductive state in a second period different from the first period, and
wherein a voltage of the decoupling wiring is constant in at least a partial period of the second period.

**2.** Currently Amended)
The switching circuit according to claim 1, wherein a voltage of the source wiring or the drain wiring changes in the second period.

**3.** Currently Amended)
The switching circuit according to claim 1, wherein the first material, the second material, and the third material are the same material.

**4.** Currently Amended)
The switching circuit according to claim 1, wherein the decoupling wiring is connected to the gate electrode and supplies a gate voltage to the gate electrode.

**5.** Currently Amended)
The switching circuit according to claim 1 or 3, wherein the decoupling wiring is disposed not to overlap the gate electrode when the semiconductor layer is viewed in a direction perpendicular to a main surface of a semiconductor substrate including the semiconductor layer.

**6.** Currently Amended)
A sample and hold circuit comprising:

the switching circuit according to claim 1;
an input terminal;
an output terminal; and
a capacitor,
wherein one of the source wiring and the drain wiring is connected to the input terminal,
wherein the other of the source wiring and the drain wiring is connected to the output terminal, and
wherein the capacitor is connected between the output terminal and a point having a predetermined constant voltage.

**7.** Currently Amended)
The sample and hold circuit according to claim 6, wherein second parasitic capacitance formed between the other of the source wiring and the drain wiring connected to the output terminal and the decoupling wiring is less than first parasitic capacitance formed between the one of the source wiring and the drain wiring connected to the input terminal and the decoupling wiring.

**8.** New)
A solid-state imaging device comprising:

an imaging unit in which a plurality of pixels, each of which outputs a pixel signal according to an amount of incident light, are disposed in a matrix shape; and
the sample and hold circuit according to claim 6 configured to sample and hold an analog signal according to the pixel signal.

## FIG. 1

100

## FIG. 2

100

# FIG. 3

ΦSH

~33

31

~100

32

Cdg

Csg

GND                    GND

# FIG. 4

ΦSH

t1          t2  t3  t4

VDD

GND

VOLTAGE OF
DECOUPLING WIRING 101

GND

VOLTAGE OF
DRAIN WIRING 31 (INPUT)

V1

V2

VOLTAGE OF
SOURCE WIRING 32 (OUTPUT)

V1

V2

STATE OF SWITCHING CIRCUIT 100

| OFF | ON | OFF | ON | OFF |
|-----|----|----|-----|-----|

FIRST
PERIOD

SECOND
ERIOD

FIG. 5

200

CAD GA CAG CAS

33

31 D S 32

FIG. 6

300

CAD GA CAG CAS

33

31 D S 32

FIG. 7

FIG. 8

FIG. 9

ΦSH

903

901

902

Csh

GND

FIG. 10

t1    t2

ΦSH

VDD

GND

Vin

V1

V2

Vout

V1

V2

FIG. 11

903

CAD

GA

CAG

CAS

A

A'

31

D

S

32

33

FIG. 12

903

31

32

GA

CAD

CAS

D

S

34

# FIG. 13

ΦSH

901 902

903

Cp

Csh

GND

# FIG. 14

ΦSH

Vin

Vout

t1  t3  t2

VDD

GND

V1

V2

V1

ΔV

V2

## INTERNATIONAL SEARCH REPORT

| International application No. |
| --- |
| PCT/JP2014/070870 |

### A. CLASSIFICATION OF SUBJECT MATTER
*H04N5/374(2011.01)i, H01L27/146(2006.01)i, H03K17/687(2006.01)i*

According to International Patent Classification (IPC) or to both national classification and IPC

### B. FIELDS SEARCHED

Minimum documentation searched (classification system followed by classification symbols)
H04N5/374, H01L27/146, H03K17/687

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| A | JP 2006-216205 A (Denso Corp.), 17 August 2006 (17.08.2006), paragraphs [0057] to [0123]; fig. 1, 2 (Family: none) | 1-7 |
| A | JP 2005-333465 A (Fujitsu Ltd.), 02 December 2005 (02.12.2005), paragraphs [0028] to [0073] & US 2005/0258874 A1 | 1-7 |
| A | JP 2011-109486 A (Sony Corp.), 02 June 2011 (02.06.2011), paragraphs [0122] to [0164] & US 2011/0115958 A1 | 1-7 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 01 October, 2014 (01.10.14) | 14 October, 2014 (14.10.14) |

| Name and mailing address of the ISA/ Japanese Patent Office | Authorized officer |
| --- | --- |
| Facsimile No. | Telephone No. |

Form PCT/ISA/210 (second sheet) (July 2009)

**INTERNATIONAL SEARCH REPORT**

International application No.

PCT/JP2014/070870

| C (Continuation). DOCUMENTS CONSIDERED TO BE RELEVANT | | |
|---|---|---|
| Category* | Citation of document, with indication, where appropriate, of the relevant passages | Relevant to claim No. |
| A | JP 2003-243521 A (NEC Corp.), 29 August 2003 (29.08.2003), paragraphs [0027] to [0081] (Family: none) | 1-7 |
| A | JP 2005-260307 A (Sanyo Electric Co., Ltd.), 22 September 2005 (22.09.2005), paragraphs [0019] to [0074] (Family: none) | 1-7 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013178198 A